# EUROPÄISCHE PATENTSCHRIFT

(11) **EP 2 338 179 B1**
(45) Veröffentlichungstag und Bekanntmachung des Hinweises auf die Patenterteilung: **13.04.2016**
(21) Anmeldenummer: 09778447.4
(22) Anmeldetag: 10.09.2009
(51) Int. Cl.: H01L 21/67, H01L 31/18

(54) **VERFAHREN ZUR BEHANDLUNG VON SUBSTRATEN UND BEHANDLUNGSEINRICHTUNG ZUR DURCHFÜHRUNG DES VERFAHRENS**
METHOD FOR THE TREATMENT OF SUBSTRATES AND TREATMENT DEVICE FOR CARRYING OUT SAID METHOD
PROCÉDÉ DE TRAITEMENT DE SUBSTRATS ET DISPOSITIF DE TRAITEMENT POUR METTRE EN OEUVRE LE PROCÉDÉ

(30) Priorität: 15.09.2008 DE 102008048540
(43) Veröffentlichungstag der Anmeldung: 29.06.2011
(73) Patentinhaber: Gebr. Schmid GmbH, 72250 Freudenstadt (DE)
(72) Erfinder: HABERMANN, Dirk, 79199 Kirchzaarten (DE)
(74) Vertreter: Patentanwälte Ruff, Wilhelm, Beier, Dauster & Partner mbB
(86) Internationale Anmeldenummer: PCT/EP2009/006566
(87) Internationale Veröffentlichungsnummer: WO 2010/028825

(56) Entgegenhaltungen:
- WO-A1-95/08406
- WO-A1-98/50947
- WO-A1-2006/025639
- US-A1- 2002 066 717
- US-A1- 2003 066 549

## Beschreibung

Die Erfindung betrifft ein Verfahren zur Behandlung von Substraten, insbesondere Solarzellen-Wafer, gemäß dem Oberbegriff des Anspruchs 1. Des Weiteren betrifft die Erfindung Substrate, insbesondere Solarzellen-Wafer, die mit einem derartigen Verfahren behandelt worden sind, sowie eine Behandlungseinrichtung zur Durchführung des Verfahrens.

Bei beispielsweise der Herstellung von konventionellen Solarzellen mit monokristallinen oder polykristallinen p-Si-Wafern wird oftmals die Oberfläche zur Verbesserung ihrer Absorptionseigenschaften mittels eines Ätzprozesses texturiert. Dieser Ätzprozess wird bei beispielsweise monokristallinem Silizium mit einem Gemisch aus Natronlauge oder Kalilauge mit Isopropylalkohol durchgeführt. Polykristallines Silizium wird mit einer Lösung aus Fluss- und Salpetersäure geätzt. Anschließend werden weitere Ätz-Reinigungsschritte durchgeführt. Ein Standard-Prozess zur Ätzung nach dem Sägen der Substrate zum Beseitigen von Sägeschäden und zur Reinigung sieht vor, dass zuerst mit DI-Wasser gereinigt wird und dann die Texturierung und Sägeschädenätzung erfolgt mit vorbeschriebenen Lösungen. Dann wird wiederum mit DI-Wasser gereinigt und danach folgt eine KOH-Ätzung oder eine NaOH-Ätzung, um eine evtl. vorhandene dünne Schicht aus porösem Silizium und SiN-Komplexen zu entfernen. Dann erfolgt wiederum eine Reinigung mit DI-Wasser und danach eine HCl-Ätzung zur Neutralisation und zum Entfernen von Restspuren von Metall. Danach erfolgt eine HF-Ätzung mit erneuter Reinigung mit DI-Wasser und dann eine Trocknung. Danach ist die Oberfläche des Silizium-Wafers für den folgenden Diffusionsprozess vorbereitet.

Bei diesem Diffusionsprozess wird ein pn-Übergang im Silizium durch die Diffusion von Phosphor in eine Tiefe von ca. 0,5µm erzeugt. Der pn-Übergang trennt dann im Betrieb der Solarzelle die durch Licht gebildeten Ladungsträger. Zur Erzeugung dieses pn-Übergangs wird der Wafer auf ca. 800°C - 950°C in einem Ofen erhitzt, wobei eine Phosphorquelle vorhanden ist. Hierbei dringt Phosphor in die Siliziumoberfläche ein, sodass eine mit Phosphor dotierte Schicht erzeugt wird. Diese ist im Gegensatz zur positiv leitenden Bor-dotierten Basis negativ leitend. Bei diesem Prozess entsteht an der Oberfläche ein Phosphorglas, das in nachfolgenden Schritten durch eine Ätzung mit HF-Säure entfernt wird. Anschließend wird eine rund 80nm dicke Schicht, die meist aus SiN:H besteht, zur Reduzierung der Reflexionen und zur Passivierung an der Siliziumoberfläche aufgebracht. Schließlich werden metallische Kontakte durch Siebdruckverfahren odgl. auf der Vorderseite und Rückseite aufgebracht. Nachteilig hierbei ist jedoch, dass H₂O-Moleküle in die SiO₂-Struktur eingebaut werden und somit ein qualitativ nicht optimales Oxid gebildet wird. Lebensdauermessungen der Ladungsträger von derartig passivierten Oberflächen zeigen erheblich schlechtere Werte gegenüber beispielsweise thermisch hergestellten Oxiden.

Die US 2003/0066549 A1 beschreibt ein Verfahren zur Behandlung von Substraten, insbesondere Halbleitersubstraten, bei dem nach verschiedenen Reinigungsschritten mit Wasser eine Oxidation des Substrats bzw. der Substratoberfläche erfolgt mit einem Gasgemisch, das Ozon enthält. Dort wird das ozonhaltige Gas bewusst und gezielt nass gemacht.

Die WO 95/08406 A1 beschreibt ebenfalls ein Verfahren zur Behandlung von Substraten, bei dem mit Ozon oxidiert wird. Allerdings wird hier nicht hauptsächlich oxidiert, sondern der Oxidationsschritt ist Teil des Trocknungsschrittes, wobei ein Marangoni-Trockner verwendet wird. Zum Trocknen wird an Stelle eines Isopropanol-Alkohol/N₂-Gasgemischs ein Alkohol-Gemisch in Kombination eingesetzt. Es geht also um ein Trocknungsverfahren unter Anwesenheit von Ozon. Dabei ist noch Lösungsmittel auf dem Substrat vorhanden während das Substrat dem Ozon ausgesetzt ist.

Die WO 89/50947 A1 beschreibt ebenfalls wie die zuvor genannte US 2003/0066549 A1 ein nasses Oxidieren, wie dies bereits aus dem Abstract deutlich wird. Dort ist nämlich erwähnt, dass die Oxidationslösung nass auf die Oberfläche aufgebracht wird.

### Aufgabe und Lösung

Der Erfindung liegt die Aufgabe zugrunde, ein eingangs genanntes Verfahren sowie dessen Verwendung und eine entsprechende Behandlungseinrichtung zu schaffen, mit denen Probleme des Standes der Technik vermieden werden können und insbesondere bessere Qualitäten der Substrate, insbesondere bei Solarzellen-Wafern, geschaffen werden können.

Gelöst wird diese Aufgabe durch ein Verfahren mit den Merkmalen des Anspruchs 1, eine Verwendung mit den Merkmalen des Anspruchs 7, und eine Behandlungseinrichtung mit den Merkmalen des Anspruchs 8. Vorteilhafte sowie bevorzugte Ausgestaltungen der Erfindung sind Gegenstand der weiteren Ansprüche und werden im folgenden näher erläutert. Dabei werden manche der Merkmale nur für einen der grundsätzlichen Erfindungsaspekte genannt, sollen jedoch unabhängig davon für sämtliche Erfindungsaspekte gelten können. Der Wortlaut der Ansprüche wird durch ausdrückliche Bezugnahme zum Inhalt der Beschreibung gemacht.

Bei dem Verfahren erfolgt das Ätzen der Substrate mehrfach mit mehreren Reinigungsschritten dazwischen, bei denen Wasser bzw. DI-Wasser verwendet wird. Erfindungsgemäß wird abschließend das Substrat getrocknet und erwärmt, um Wasser von der Oberfläche möglichst zu entfernen zur Trocknung der Substrate. Anschließend erfolgt eine Oxidation des Substrats bzw. von dessen Oberfläche mit einem Gasgemisch, welches zumindest einen geringen Anteil an Ozon enthält. Dadurch ist es möglich, dass eben im Gegensatz zu früherem nassem Oxidieren beim sogenannten trockenen Oxidieren der Einbau von H₂O-Molekülen in die Siliziumschicht vermieden wird. Das Trocknen und Erwärmen kann dabei mit einem erhitzten Gasgemisch erfolgen.

Vorteilhaft kann für die Oxidation bzw. die sogenannte trockene Oxidation ein Gasgemisch verwendet werden, welches N₂, O₂ oder O₃ enthält als Trägergas, beispielsweise auch ein Gemisch aus mehreren dieser Verbindungen.

Das Trocknen und Erwärmen des Substrats kann zwar grundsätzlich auch bei Raumtemperatur erfolgen, vorteilhaft ist jedoch ein Erwärmen auf höhere Temperaturen vorgesehen, beispielsweise auf mindestens 50°C. Besonders vorteilhaft wird auf mindestens 100°C bis 150°C erwärmt.

In Ausgestaltung der Erfindung kann vor dem Schritt der Trocknung und Erwärmung des Substrats noch ein weiterer Reinigungsschritt mit DI-Wasser erfolgen, also beispielsweise nach einer letzten HF-Ätzung.

Vorteilhaft wird das Verfahren in einem In-Line-Verfahren durchgeführt, alternativ in einem Batch-Prozess. So ist ein hoher Durchsatz mit effizienter Durchführung erreichbar.

Zwar kann das vorgenannte Verfahren für viele Zwecke verwendet werden. Besonders vorteilhaft wird es zur Bearbeitung von Substraten für Solarzellen bzw. für Solarzellen-Wafer verwendet. Gerade hier eignen sich auch die vorgenannten In-Line-Verfahren oder Batch-Verfahren um große Mengen zu bearbeiten.

Ein mit dem erfindungsgemäßen Verfahren behandelter Solarzellen-Wafer kann entweder eine Schicht aus Silizium aufweisen, die so behandelt wird. Alternativ kann er vollständig aus Siliziummaterial bestehen.

Die erfindungsgemäße Behandlungseinrichtung für Substrate weist mindestens eine Ätzeinrichtung für die Substrate und wenigstens eine Reinigungseinrichtung mit Wasser bzw. DI-Wasser auf. Des Weiteren ist wenigstens eine Trockenstation mit Erwärmung vorgesehen für eine Trocknung der Oberfläche der Substrate und Entfernung von Wasser, wobei hinter der Trockenstation eine Oxidationsstation für das Substrat bzw. die Substratoberfläche angeordnet ist mit Einbringung eines Gasgemischs, das zumindest einen geringen Anteil an Ozon enthält. Die genaue Ausbildung der Behandlungseinrichtung im Einzelnen mit verschiedenen Einrichtungen und Arbeitsstationen kann den vorbeschriebenen Verfahrensschritten entnommen werden und daran angepasst sein.

Diese und weitere Merkmale gehen außer aus den Ansprüchen auch aus der Beschreibung und der Zeichnung hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Gültigkeit.

### Detaillierte Beschreibung des Ausführungsbeispiels

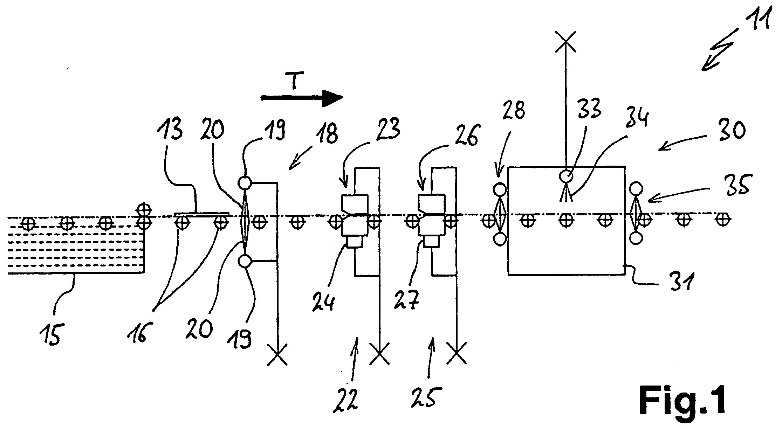

In Fig. 1 ist schematisch eine Behandlungseinrichtung 11 dargestellt, die für sich erläutert werden soll sowie anhand der auch das erfindungsgemäße Verfahren erläutert wird.

Die Behandlungseinrichtung 11 ist für Substrate vorgesehen, von denen ein Substrat 13 dargestellt ist. Es wird in der Transportrichtung T bewegt und kommt aus einer Ätzeinrichtung 15, welche auf übliche Art und Weise aufgebaut sein kann. Der Transport des Substrats 13 bzw. einer Reihe aufeinanderfolgender Substrate, die hier der Übersichtlichkeit halber nicht dargestellt sind, erfolgt auf Rollen 16, wobei die Rollen 16 eine Art Rollenbahn bilden.

Nach der Ätzeinrichtung 15 durchläuft das Substrat 13 die Spülstation 18. Mittels Spüldüsen 19 wird DI-Wasser 20 von oben und von unten auf die Substrate 13 aufgebracht zum Spülen bzw. Reinigen der Oberfläche des Substrats. Derartige Spülstationen können auch vor der Ätzeinrichtung 15 vorgesehen sein.

Nach der Spülstation 18 durchläuft das Substrat 13 in Transportrichtung T die erste Trockenstation 22. Diese weist ein Gebläse 23 auf und außerdem noch eine Erwärmung 24. Hierfür können beispielsweise normale elektrische Heizungen oder auch Strahlungsheizkörper verwendet werden sowie übliche Gebläse. Durch die Gebläsewirkung wird zum einen auf den Oberflächen des Substrats 13 befindliches Wasser entfernt bzw. über die Ränder weggetrieben. Des Weiteren verdunstet durch die Wirkung der Erwärmung 24 ein Teil des Wassers. Des Weiteren kann die Erwärmung für eine vorteilhafte Vorbereitung der Substrate für eine nachfolgende Oxidation dienen.

Nach der ersten Trockenstation 22 folgt eine zweite Trockenstation 25, die auch ein Gebläse 26 und eine Erwärmung 27 aufweist. Es sind hier zwei Trockenstationen vorgesehen, damit die Einrichtung 11 im Durchlaufbetrieb betrieben werden kann und sichergestellt wird, dass die Substrate 13 auch tatsächlich getrocknet und gegebenenfalls erwärmt werden. Diese können auch identisch sein.

Nach der zweiten Trockenstation 25 laufen die Substrate 13 durch eine Schleuse 28 in eine Oxidationsstation 30 ein. Diese weist eine Kammer 31 auf, in der oberhalb der Substrate 13 bzw. der zum Transport dienenden Rollen 16 eine Düse 33 vorgesehen ist. Mittels der Düse 33 wird ein Oxidationsgas 34 in die Kammer 31 eingebracht zur Oxidation der Substrate 13 bzw. ihrer Oberflächen. Mittels einer Schleuse 35 wird ein Substrat 13 dann aus der Oxidationsstation 30 ausgeschleust.

Wie zuvor erläutert worden ist, kann an den Trockenstationen 22 und 25 eine Erwärmung der Substrate 13 auf mindestens 50°C erfolgen, vorteilhaft sogar noch mehr, beispielsweise 100°C bis 150°C. Durch diese Erwärmung erfolgt nicht nur ein besseres Trocknen der Substrate, also das Entfernen von Wasser, sondern auch eine Vorbereitung für die Oxidation, sodass anschließend eine optimierte Passivierung und Vorbereitung der Oberfläche für beispielsweise eine Phosphor-Diffusion möglich wird. Des Weiteren ist es durch die Erwärmung an den Trockenstationen möglich, dass die anschließende Oxidation in einer Einrichtung ohne eigene Heizung oder Erwärmung stattfinden kann, wobei durch die Erwärmung auch die Oxidation besser abläuft. Durch die trockene Oxidation in der Oxidationsstation 30 wird auch ein erneutes Einlagern von H₂O-Molekülen in die Siliziumstruktur bzw. die erzeugte SiO₂-Struktur vermieden. Dieser Einbau von H₂O-Molekülen führt nämlich bei Lebensdauermessungen der Ladungsträger zu schlechteren Werten gegenüber den erfindungsgemäß trocken und erwärmt oxidierten Substraten.

Wie eingangs beschrieben worden ist, kann das Oxidationsgas 34 in der Oxidationsstation 30 Stickstoff, Sauerstoff oder Ozon sein. Auf alle Fälle jedoch sollte ein zumindest geringer Mindestanteil von Ozon enthalten sein, da sich dieses unter anderem aufgrund seiner hohen Reaktivität zur Oxidation besonders gut eignet.

## Patentansprüche

1. Verfahren zur Behandlung von Substraten (13), insbesondere Solarzellen, wobei die Substrate (13) zumindest an ihrer Außenseite siliziumhaltig sind bzw. Siliziummaterial aufweisen, wobei während der Behandlung mehrfaches Ätzen der Substrate erfolgt und mehrere Reinigungsschritte mit Wasser bzw. DI-Wasser (20) dazwischen, wobei abschließend das Substrat (13) getrocknet und erwärmt wird zur möglichst weitgehenden Trocknung der Oberfläche und Entfernung von Wasser, wobei anschließend eine Oxidation des Substrats (13) bzw. der Substratoberfläche erfolgt mit einem Gasgemisch (34), das zumindest einen geringen Anteil an Ozon enthält, **dadurch gekennzeichnet, dass** das Substrat (13) trocken oxidiert wird.

2. Verfahren nach Anspruch 1, **dadurch gekennzeichnet, dass** das Substrat (13) getrocknet und erwärmt wird mit einem erhitzten Gas.

3. Verfahren nach Anspruch 1 oder 2, **dadurch gekennzeichnet, dass** das Gasgemisch (34) für die Oxidation Bestandteile der folgenden Gruppe aufweist: N₂, O₂, O₃.

4. Verfahren nach einem der vorhergehenden Ansprüche, **dadurch gekennzeichnet, dass** das Substrat (13) während des Schritts der Trocknung und Erwärmung auf eine Temperatur von mindestens 50°C gebracht wird, vorzugsweise mindestens 100°C bis 150°C.

5. Verfahren nach einem der vorhergehenden Ansprüche, **dadurch gekennzeichnet, dass** direkt vor dem Schritt der Trocknung und Erwärmung das Substrat (13) noch einmal mit DI-Wasser (20) gereinigt wird.

6. Verfahren nach einem der vorhergehenden Ansprüche, **dadurch gekennzeichnet, dass** es in einem In-Line-Verfahren durchgeführt wird.

7. Verwendung eines Verfahrens nach einem der vorhergehenden Ansprüche zur Bearbeitung von Substraten (13) für Solarzellen bzw. Solarzellenwafer.

8. Behandlungseinrichtung für Substrate (13), insbesondere Solarzellen, wobei die Substrate zumindest an ihrer Außenseite siliziumhaltig sind bzw. Siliziummaterial aufweisen, wobei die Behandlungseinrichtung (11) mindestens eine Ätzeinrichtung (15) für die Substrate (13) aufweist und wenigstens eine Reinigungseinrichtung (18) mit Wasser bzw. DI-Wasser (34), **dadurch gekennzeichnet, dass** wenigstens eine Trockenstation (22, 25) mit Erwärmung (24, 27) vorgesehen ist für eine Trocknung der Oberfläche der Substrate (13) und Entfernung von Wasser, wobei hinter der Trockenstation (22, 25) eine Oxidationsstation (30) für das Substrat (13) bzw. für die Substratoberfläche angeordnet ist mit Einbringung eines Gasgemischs (34), das zumindest einen geringen Anteil an Ozon enthält.

9. Behandlungseinrichtung nach Anspruch 8, **dadurch gekennzeichnet, dass** zwei Trocknungsstationen (22, 25) vorgesehen sind.

## Claims

1. Method for the treatment of substrates (13), in particular solar cells, wherein the substrates (13) contain silicon or have silicon material at least on their outer side, wherein during the treatment, multiple etching of the substrates occurs and several cleaning steps with water or DI water (20) therebetween, wherein the substrate (13) is then dried and heated to dry the surface and remove water to the greatest extent possible, wherein an oxidation of the substrate (13) or the substrate surface then occurs with a gas mixture (34) which contains at least a low proportion of ozone, **characterised in that** the substrate (13) is oxidised dry.

2. Method according to claim 1, **characterised in that** the substrate (13) is dried and heated using a heated gas.

3. Method according to claim 1 or 2, **characterised in that** the gas mixture (34) for the oxidation has components of the following group: N₂, O₂, O₃.

4. Method according to one of the preceding claims, **characterised in that** the substrate (13) is brought to a temperature of at least 50°C, preferably at least 100 °C to 150 °C, during the step of drying and heating.

5. Method according to one of the preceding claims, **characterised in that**, directly before the step of drying and heating, the substrate (13) is cleaned once again with DI water (20).

6. Method according to one of the preceding claims, charaterised in that it is carried out in an in-line method.

7. Use of a method according to one of the preceding claims for processing substrates (13) for solar cells or solar cell wafers.

8. Treatment device for substrates (13), in particular solar cells, wherein the substrates contain silicon or have silicon material at least on their outer side, wherein the treatment device (11) has at least one etching device (15) for the substrates (13) and at least one cleaning device (18) with water or DI water (34), **characterised in that** at least one drying station (22, 25) is provided with heating (24, 27) for drying the surface of the substrates (13) and removing water, wherein an oxidisation station (30) for the substrate (13) or for the substrate surface is arranged behind the drying station (22, 25) with introduction of a gas mixture (34) which contains at least a low proportion of ozone.

9. Treatment device according to claim 8, **characterised in that** two drying stations (22, 25) are provided.

## Revendications

1. Procédé de traitement de substrats (13), en particulier de cellules solaires, selon lequel les substrats (13) renferment du silicium ou un matériau à base de silicium au moins sur leur face externe, et pendant le traitement on effectue à plusieurs reprises une attaque chimique du substrat et entre ces attaques, plusieurs étapes de nettoyage avec de l'eau ou de l'eau désionisée (20), puis le substrat (13) est séché et chauffé pour permettre un séchage de la surface et une élimination de l'eau, aussi large que possible puis, on effectue une oxydation du substrat (13) ou de la surface du substrat avec un mélange gazeux (34) qui renferme au moins une faible proportion d'ozone,
**caractérisé en ce que**
le substrat (13) est oxydé à sec.

2. Procédé conforme à la revendication 1,
**caractérisé en ce que**
le substrat (13) est séché et chauffé avec un gaz chauffé.

3. Procédé conforme à la revendication 1 ou 2,
**caractérisé en ce que**
le mélange gazeux (34) utilisé pour l'oxydation renferme des constituants du groupe suivant : N₂, O₂, O₃.

4. Procédé conforme à l'une des revendications précédentes,
**caractérisé en ce que**
pendant l'étape de séchage et de chauffage le substrat (13) est amené à une température d'au moins 50 °C, de préférence d'au moins 100 °C à 150 °C.

5. Procédé conforme à l'une des revendications précédentes,
**caractérisé en ce que**
directement avant l'étape de séchage et de chauffage, le substrat (13) est encore une fois nettoyé avec de l'eau désionisée (20).

6. Procédé conforme à l'une des revendications précédentes,
**caractérisé en ce qu'**
il est mis en oeuvre sous la forme d'un procédé en ligne.

7. Utilisation d'un procédé conforme à l'une quelconque des revendications précédentes,
pour traiter des substrats (13) destinés à des cellules solaires ou à des plaquettes de cellules solaires.

8. Dispositif de traitement de substrats (13) en particulier de cellules solaires dans lequel les substrats renferment du silicium ou un matériau à base de silicium au moins sur leur face externe, ce dispositif de traitement (11) comprenant au moins un dispositif d'attaque chimique (15) des substrats (13) et au moins un dispositif de nettoyage (18) avec de l'eau ou de l'eau désionisée (34),
**caractérisé en ce qu'**
il est prévu au moins un poste de séchage (22, 25) équipé d'organes de chauffage (24, 27) pour permettre le séchage de la surface du substrat (13) et l'élimination d'eau, et à l'arrière du poste de séchage (22, 25) un poste d'oxydation (30) du substrat (13) ou de la surface du substrat, avec apport d'un mélange gazeux (34) qui renferme au moins une faible proportion d'ozone.

9. Dispositif de traitement conforme à la revendication 8,
**caractérisé en ce qu'**
il est prévu deux postes de séchage (22, 25).
